# EUROPEAN PATENT SPECIFICATION

(11) **EP 4 135 017 B1**
(45) Date of publication and mention of the grant of the patent: **07.05.2025**
(21) Application number: 21784584.1
(22) Date of filing: 29.03.2021
(51) Int. Cl.: G01R 31/28, G01D 21/00, G01D 3/08

(54) **INTEGRATED CIRCUIT**
INTEGRIERTE SCHALTUNG
CIRCUIT INTÉGRÉ

(30) Priority: 09.04.2020 JP 2020070470
(43) Date of publication of application: 15.02.2023
(73) Proprietor: Minebea Mitsumi Inc., Kitasaku-gun, Nagano 3890293 (JP)
(72) Inventor: Otsuka, Shinya, Tama-shi, Tokyo 206-8567 (JP); Takehana, Hiroaki, Tama-shi, Tokyo 206-8567 (JP)
(74) Representative: Dennemeyer & Associates S.A.
(86) International application number: PCT/JP2021/013282
(87) International publication number: WO 2021/205925

(56) References cited:
- CN-A- 103 308 850
- JP-A- 2001 134 458
- JP-A- 2008 524 630
- JP-A- 2012 151 666
- JP-A- 2013 257 178
- JP-A- 2013 257 178
- JP-A- H0 856 160
- JP-A- H04 150 415
- US-A1- 2011 273 197
- US-A1- 2016 274 181
- US-A1- 2018 141 566

## Description

### [Technical Field]

The present invention relates to an integrated circuit.

### [Background Art]

In Patent Document 1 cited below, a technique related to a method of inspecting a memory in a memory inspection mode is disclosed, that relates to an analog-to-digital conversion circuit having multiple circuit parts each of which is configured to include a comparator and a memory. Examples of integrated circuit devices with monitoring or diagnostic functions are disclosed in US 2016/274181, US 2018/141566, CN 103308850 and JP 2013 257178.

### [Related Art Documents]

### [Patent Documents]

[Patent Document 1] Japanese Laid-Open Patent Application No. 2015-201879

### [Summary of the Invention]

### [Problem to be Solved by the Invention]

Meanwhile, conventionally, as a diagnostic method of an integrated circuit that executes processing on a sensor signal output from a sensor, a diagnostic method that executes diagnosis of the integrated circuit based on the value of an output signal (i.e., a sensor signal or a test signal after processed by the integrated circuit) output from the integrated circuit, in a state of the sensor being connected to the input terminal, or in a state of a generation source of the test signal being connected to the input terminal, has been used. In such an integrated circuit, abnormalities are likely to occur in an amplifier and an A-D converter, and it is favorable to detect such abnormalities by diagnosing the integrated circuit.

However, in the conventional diagnostic method, the value of the output signal output from the integrated circuit is affected by an influence of the outside of the integrated circuit (e.g., the sensor, a connection line to the sensor, the generation source of the test signal, a connection line to the generation source of the test signal, etc.) and an influence of the inside of the integrated circuit; therefore, it is not possible to easily and securely determine whether or not the integrated circuit is functioning normally, only by the value of the output signal output from the integrated circuit.

### [Means for Solving Problem]

According to the invention, there is provided an integrated circuit as defined in appended claim 1. Other advantageous embodiments are defined in the corresponding dependent claims.

There is also disclosed an integrated circuit that executes processing on a sensor signal input from a sensor via an input terminal. The integrated circuit includes a processing path through which a series of processing is executed on the sensor signal; and a test signal generation source configured to generate a test signal for self-diagnosis, to feed the test signal into the processing path.

### [Advantageous Effects of the Invention]

By the integrated circuit according to the one embodiment, whether or not the integrated circuit is functioning normally can be determined easily and securely.

### [Brief Description of the Drawings]

FIG. 1 is a diagram illustrating a configuration of a diagnostic system according to the one embodiment;
FIG. 2 is a diagram illustrating a processing path in an IC according to the one embodiment;
FIG. 3 is a flow chart illustrating the order of operations in the diagnostic mode executed by the IC according to the one embodiment; and
FIG. 4 is a flow chart illustrating steps of a determination process executed by an MCU according to the one embodiment.

### [Embodiments for Carrying Out the Invention]

In the following, with reference to the drawings, the one embodiment will be described.

### (Configuration of diagnostic system 10)

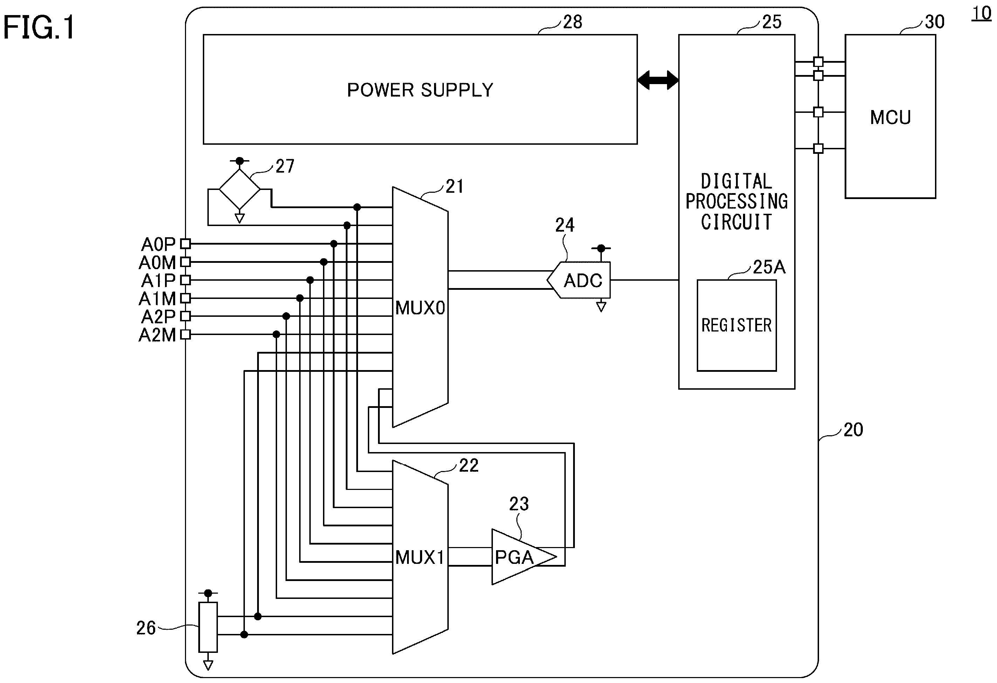

FIG. 1 is a diagram illustrating a configuration of a diagnostic system 10 according to the one embodiment. A diagnostic system 10 illustrated in FIG. 1 is provided with an IC (Integrated Circuit) 20 and an MCU (Micro Controller Unit) 30. The IC 20 is an integrated circuit that executes predetermined processing on a sensor signal output from a sensor. For example, the IC 20 can convert the sensor signal output from the sensor from an analog signal to a digital signal. The IC 20 has a "diagnostic mode". In the "diagnostic mode," the IC 20 generates a test signal by a test signal generation source 26 provided inside, and, by feeding the test signal into a processing path 20A of the sensor signal, can execute a series of processing on the test signal (same processing as executed on the sensor signal). The MCU 30 is an example of a "determination means" that obtains from the IC 20 the test signal after the series of processing has been executed, and based on the obtained test signal, can execute determination on fault diagnosis of the IC 20.

### (Configuration of IC 20)

As illustrated in FIG. 1, the IC 20 includes a first multiplexer 21, a second multiplexer 22, a PGA (Programmable Gain Amplifier) 23, an A-D converter 24, a digital processing circuit 25, a test signal generation source 26, an internal sensor 27 (e.g., a temperature sensor), and a power supply 28.

Note that in the example illustrated in FIG. 1, the IC 20 is provided with three pairs of input terminals A0P, A0M, A1P, A1M, A2P, and A2M, where each pair includes two input terminals (a +terminal and a -terminal). Accordingly, the IC 20 can be connected with three sensors, and for each pair of input terminals, two output signal lines connected to a differential sensor, or one output signal line connected to a single-ended sensor can be connected.

The first multiplexer 21 (denoted as MUX0 in the figure) is connected to each of the multiple input terminals and the internal sensor 27. The first multiplexer 21 selects one of sensor signals from among multiple sensor signals input from the multiple input terminals and the internal sensor 27, to output the selected one of the sensor signals to the A-D converter 24. Also, the first multiplexer 21 is an example of a "switching means" that is connected to the test signal generation source 26, and can select a test signal output from the test signal generation source 26, to output the test signal to the A-D converter 24.

The second multiplexer 22 (denoted as MUX1 in the figure) is connected to each of the multiple input terminals and the internal sensor 27. The second multiplexer 22 selects one of the sensor signals from among the multiple sensor signals input from the multiple input terminals and the internal sensor 27, to output the selected one of the sensor signals to the PGA 23. Also, the second multiplexer 22 is an example of a "switching means" that is connected to the test signal generation source 26, and can select the test signal output from the test signal generation source 26, to output the test signal to the PGA 23.

The PGA 23 is connected between the output terminals of the second multiplexer 22 and the input terminals of the first multiplexer 21. The PGA 23 is an amplifier whose gain can be changed. The PGA 23 amplifies one of the sensor signals output from the second multiplexer 22, to output the amplified signal to the input terminals of the first multiplexer 21. In this case, the first multiplexer 21 can select the one of the sensor signals output from the PGA 23, to output the one of the sensor signals to the A-D converter 24. In other words, the first multiplexer 21 can output the one of the sensor signals amplified by the PGA 23 to the A-D converter 24.

The A-D converter 24 (denoted as "ADC" in the figure) is connected to the output terminals of the first multiplexer 21. The A-D converter 24 converts one of the sensor signals (one sensor signal not amplified by the PGA 23 or one sensor signal amplified by the PGA 23) output from the first multiplexer 21, from an analog signal to a digital signal, to output the converted signal to the digital processing circuit 25.

The digital processing circuit 25 is connected to the output terminal of the A-D converter 24. The digital processing circuit 25 includes a register 25A. The register 25A stores one sensor signal output from the A-D converter 24. Also, the digital processing circuit 25 applies predetermined digital signal processing (e.g., digital filtering, data transmission to the MCU 30 via I2C communication, etc.) to one sensor signal (digital signal) output from the A-D converter 24 or one sensor signal (digital signal) stored in the register 25A. For example, the digital processing circuit 25 outputs one sensor signal stored in the register 25A to the MCU 30 via the output terminal of the IC 20.

In the "diagnostic mode", the test signal generation source 26 generates a test signal for self-diagnosis to self-diagnose the state of the processing path 20A of the sensor signal, and feeds the test signal into the processing path 20A of the sensor signal. The output terminals of the test signal generation source 26 are connected to both of the input terminals of the first multiplexer 21 and the input terminals of the second multiplexer 22. In the present embodiment, the processing path 20A of the sensor signal into which the test signal is fed includes, as processing blocks, the second multiplexer 22, the PGA 23, the first multiplexer 21, and the A-D converter 24.

The power supply 28 generates electric power required for the respective components of the IC 20 (the PGA 23, the A-D converter 24, and the digital processing circuit 25), to supply the electric power to the respective components of the IC 20 (the PGA 23, the A-D converter 24, and the digital processing circuit 25).

### (Processing path 20A of sensor signal)

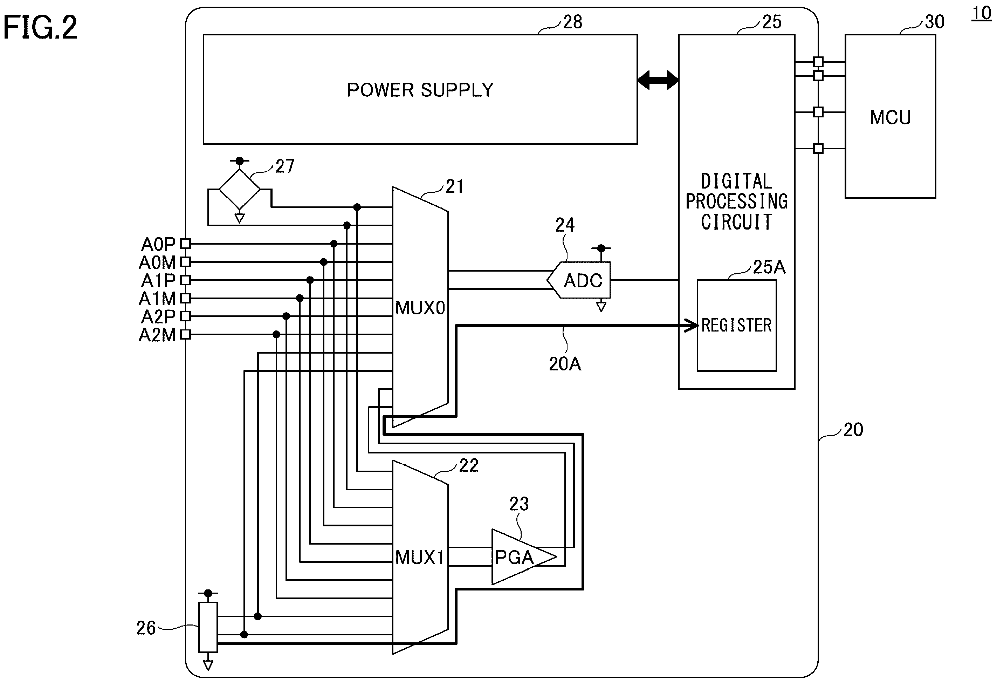

FIG. 2 is a diagram illustrating a processing path 20A in the IC 20 according to the one embodiment. In FIG. 2, the processing path 20A in the IC 20 is indicated by an arrow.

As illustrated in FIG. 2, in the "diagnostic mode" of the IC 20, a test signal generated by the test signal generation source 26 is fed into the signal processing path 20A of the sensor signal. Then, the test signal fed into the processing path 20A is input into the PGA 23 via the second multiplexer 22, and amplified by the PGA 23 with a predetermined gain.

The test signal amplified by the PGA 23 is input into the A-D converter 24 through the first multiplexer 21, and converted from an analog signal to a digital signal by the A-D converter 24. The test signal converted to the digital signal by the A-D converter 24 is stored in the register 25A of the digital processing circuit 25.

Note that in the "diagnostic mode", the test signal generation source 26 feeds two test signals S1 and S2 sequentially into the path illustrated in FIG. 2. In addition, the PGA 23 causes the gain of the test signal S1 fed first and the gain of the test signal S2 fed second to be different from each other. For example, in the present embodiment, the PGA 23 amplifies the test signal S1 with a gain of 16 times, and amplifies the test signal S2 with a gain of 32 times (i.e., twice the gain of the test signal S1). Accordingly, the test signal S1 amplified 16 times and the test signal S2 amplified 32 times are stored in the register 25A of the digital processing circuit 25.

The two test signals S1 and S2 stored in the register 25A of the digital processing circuit 25 are read by the MCU 30, to be used for determining a diagnostic result of the IC 20.

### (Order of operations in diagnostic mode)

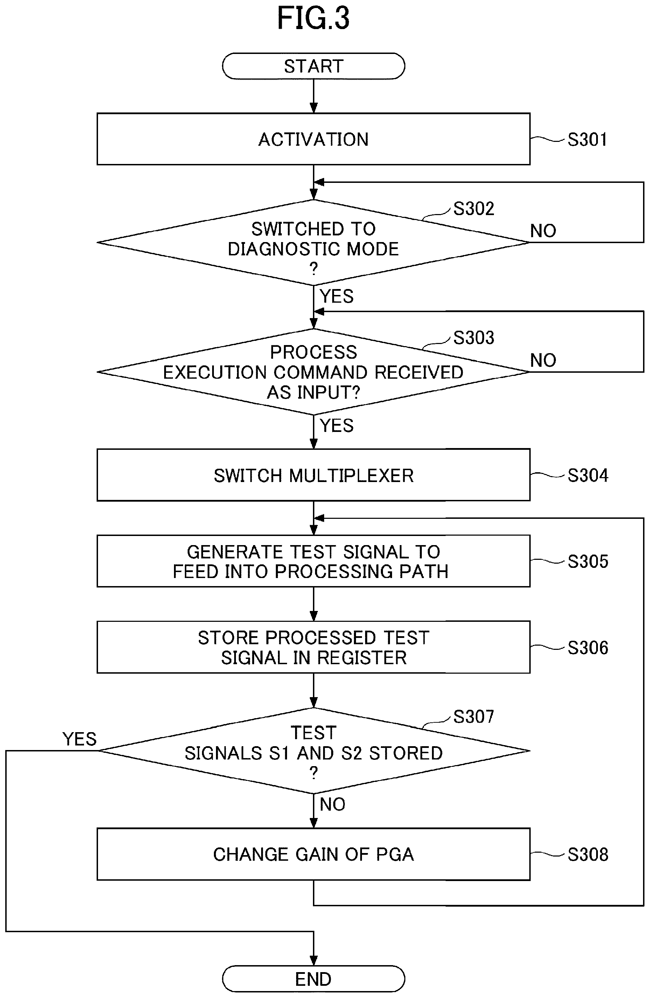

FIG. 3 is a flow chart illustrating the order of operations in the diagnostic mode executed by the IC 20 according to the one embodiment.

First, the IC 20 is activated when the power is switched on by a user (Step S301).

Next, the IC 20 determines whether or not the mode has been switched to the "diagnostic mode" (Step S302). For example, the IC 20 determines that the mode has been switched to the "diagnostic mode" when the user has made settings to switch the register to the "diagnostic mode."

If it is determined at Step S302 that the mode has not been switched to the "diagnostic mode" (NO at Step S302), the IC 20 executes the determination process at Step S302 again.

On the other hand, if it is determined at Step S302 that the mode has been switched to the "diagnostic mode" (YES at Step S302), the IC 20 determines whether a predetermined processing execution command has been input from the user (Step S303).

If it is determined at Step S303 that a predetermined processing execution command has not been input (NO at Step S303), the IC 20 executes the determination process at Step S303 again.

On the other hand, if it is determined at Step S303 that a predetermined processing execution command has been input (YES at Step S303), the IC 20 switches the first multiplexer 21 and the second multiplexer 22 so as to have a test signal fed into the processing path 20A of the sensor signal (Step S304).

Then, the IC 20 causes the test signal generation source 26 to generate a first test signal S1, and to feed the test signal S1 into the sensor signal processing path 20A (Step S305).

Accordingly, once a series of processing (amplification processing and A-D conversion processing) is executed on the test signal S1, the digital processing circuit 25 stores the test signal S1 output from the A-D converter 24 (i.e., the test signal S1 after the series of processing has been executed) in the register 25A (Step S306).

Next, the IC 20 determines whether or not a process for the second test signal S2 has been completed (i.e., whether or not both test signals S1 and S2 were stored in the register 25A) (Step S307).

If it is determined at Step S307 that a process for the second test signal S2 has not been completed (NO at Step S307), the IC 20 changes the gain of the PGA 23 to twice the gain of the first time (Step S308), and then, executes steps from Steps S305 to S306 again to execute the series of processing on the second test signal S2, and stores the test signal S2 after the series of processing has been executed, in the register 25A.

Then, if it is determined at Step S307 that the process for the second test signal S2 has been completed (YES at Step S307), the IC 20 ends the series of processing illustrated in FIG. 3.

Note that the predetermined processing execution command described above is common to that in the "normal operation mode". When the predetermined processing execution command is input in the "normal operation mode," the IC 20 feeds a sensor signal into the processing path 20A of the sensor signal, to execute a series of processing (amplification processing and A-D conversion processing) on the sensor signal.

### (Steps of determination process)

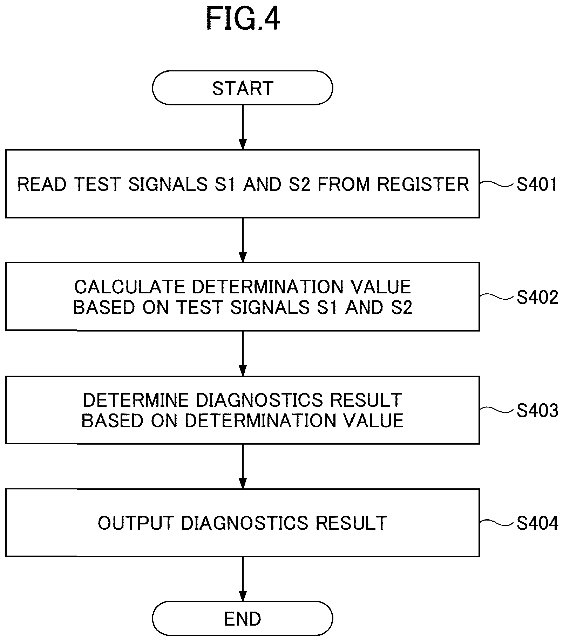

FIG. 4 is a flow chart illustrating steps of a determination process executed by the MCU 30 according to the one embodiment.

First, the MCU 30 reads the two test signals S1 and S2 from the register 25A provided in the IC 20 (Step S401).

Next, the MCU 30 calculates a determination value based on the two test signals S1 and S2 according to a predetermined calculation formula (Step S402). Then, the MCU 30 determines the diagnostic result of the IC 20, based on the determination value calculated at Step S402 (Step S403).

For example, the MCU 30 calculates the determination value according to the predetermined calculation formula {S2/S1}. Then, the MCU 30 determines that the diagnostic result of the IC 20 is "normal" if the calculated determination value is within a predetermined numerical range centered around "2" (e.g., 1.9 to 2.1). On the other hand, the MCU 30 determines that the diagnostic result of the IC 20 is "abnormal" if the calculated determination value is outside the predetermined numerical range centered around "2". A determination result being "abnormal" indicates that there is an abnormality at some location related to the processing path 20A inside the IC 20 (the PGA 23, the A-D converter 24, the power supply 28, etc.).

This is because, as already described, in the present embodiment, the gain used when amplifying the second test signal S2 by the PGA 23 is set to twice (i.e. 32 times) the gain (16 times) used when amplifying the first test signal S1 by the PGA 23, and hence, if there is no abnormality along the processing path 20A of the sensor signal to which the two test signals S1 and S2 are fed, the determination value calculated by the predetermined calculation formula (S2/S1) should be "2".

Then, the MCU 30 outputs the diagnosis result ("normal" or "abnormal") determined at Step S403 by a predetermined output method (Step S404), and ends the series of processing illustrated in FIG. 4. As the predetermined output method, for example, a method of outputting to a higher-level application, to cause the higher-level application to notify the user by a predetermined notice method (e.g., display, audio output, etc.), may be considered. However, the method is not limited as such; the predetermined output method may be a method of storing the diagnostic result in a memory, a method of transmitting the diagnostic result to the outside, or the like.

As described above, the IC 20 according to the one embodiment is the IC 20 that executes processing on a sensor signal input from a sensor via the input terminal, and is provided with the processing path 20A that executes a series of processing on the sensor signal, and the test signal generation source 26 that generates a test signal for self-diagnosis, and feeds the test signal into the processing path 20A.

Accordingly, the IC 20 according to the one embodiment can execute self-diagnosis with a stable test signal that is not affected by the connection state of the sensor to the input terminal. In other words, in the IC 20 according to the one embodiment, it is obvious that the IC 20 is abnormal if the value of the test signal output from the IC 20 is abnormal, and the IC 20 is normal if the value of the test signal output from the IC 20 is normal. Therefore, by the IC 20 according to the one embodiment, whether or not the IC 20 is functioning normally can be determined easily and securely.

Also, the IC 20 according to the one embodiment further includes the first multiplexer 21 and the second multiplexer 22 that switch a signal to be fed into the processing path 20A from a sensor signal to a test signal.

Accordingly, in the IC 20 according to the one embodiment, feeding of a test signal from the test signal generation source 26 to the processing path 20A for a sensor signal can be implemented with a relatively simple configuration. Also, the IC 20 according to the one embodiment can easily make switching between the "normal operation mode" and the "diagnostic mode."

Also, in the IC 20 according to the one embodiment, the test signal generation source 26 feeds multiple test signals sequentially into the processing path 20A, and the PGA 23 provided in the processing path 20A amplifies the multiple test signals with respective gains different from one another.

Accordingly, the IC 20 according to the one embodiment can determine relatively easily and securely whether or not the multiple test signals output from the processing path 20A have been amplified normally, by comparing the values of the multiple test signals.

Also, the diagnostic system 10 according to the one embodiment includes the IC 20, and the MCU 30 that has a function as a determination device to determine a result of self-diagnosis of the IC 20, based on a test signal after a series of processing has been executed on the processing path 20A.

Accordingly, the diagnostic system 10 according to the one embodiment can determine easily and securely by the MCU 30, whether or not the IC 20 is functioning normally.

As above, the one embodiment of the present invention have been described; note that the present invention is not limited to such an embodiment.

For example, in the one embodiment, although the function as the "determination device" is provided in the MCU 30 outside the IC 20, it is not limited as such; the function as the "determination device" may be provided inside the IC 20 (digital processing circuit 25) or on an external device other than the MCU 30.

Also, for example, in the one embodiment, although examples have been described in which the present invention is applied to the IC 20 that executes amplification and A-D conversion of a sensor signal, it is not limited as such; the present invention can be applied to any integrated circuit that can execute some processing on a sensor signal.

For example, the IC 20 described in the above embodiment may be used, in a load detector that detects the load applied to an object, as a what-is-called AFE (Analog Front End) that connects a strain gauge to output an analog signal and a microcomputer to execute digital processing to amplify and A-D convert the analog signal. However, the connection is not limited as such; the IC 20 may be connected to a sensor other than a strain gauge, and may be used in a system configuration other than the detection system 10 described in the embodiment as above.

The present international application claims priority to Japanese Patent Application No. 2020-070470 filed on April 9, 2020.

### [List of Reference Numerals]

10 diagnostic system
20 IC (integrated circuit)
20A processing path
21 first multiplexer (switching means)
22 second multiplexer (switching means)
23 PGA
24 A-D converter
25 digital processing circuit
25A register
26 test signal generation source
27 internal sensor
28 power supply
30 MCU (determination device)
A0P, A0M, A1P, A1M, A2P, A2M input terminal

## Claims

1. An integrated circuit (20) that executes processing on a sensor signal input from a sensor via an input terminal, comprising:
a processing path (20A) through which a series of processing is executed on the sensor signal;
a test signal generation source (26) configured to generate a test signal for self-diagnosis, and to feed the test signal into the processing path;
a register (25A) configured to store the test signal; and
a determination means (30) configured to determine a result of the self-diagnosis, based on the test signal after the series of processing has been executed through the processing path,
wherein the processing path includes an amplifier (23) configured to amplify the test signal with a variable gain,
wherein the test signal generation source feeds a plurality of test signals sequentially into the processing path,
wherein the amplifier is configured to amplify a first test signal of the plurality of test signals with a first gain, and amplify a second test signal of the plurality of test signals with a second gain different from the first gain,
wherein the register is configured to store a first processed signal that is the first test signal amplified with the first gain, and a second processed signal that is the second test signal amplified with the second gain, and
wherein the determination means is configured to determine the result of the self-diagnosis, based on the first processed signal and the second processed signal.

2. The integrated circuit as claimed in claim 1, further comprising:
a switching means (21, 22)_ configured to switch a signal fed into the processing path (20A) from the sensor signal to the test signal.

3. The integrated circuit as claimed in claim 2, wherein the integrated circuit has a normal operation mode and a diagnostic mode, and
wherein the switching means feeds the sensor signal into the processing path in the normal operation mode, and feeds the test signal into the processing path in the diagnostic mode.

4. The integrated circuit as claimed in any one of claims 1 to 3, wherein the processing path (20A) includes an A-D converter (24) to convert the test signal from an analog signal to a digital signal.

5. A diagnostic system (10) comprising:
the integrated circuit as claimed in any one of claims 1 to 4; and
a determination device configured to determine a result of the self-diagnosis, based on the test signal after the series of processing has been executed through the processing path.

## Patentansprüche

1. Integrierte Schaltung (20), die eine Verarbeitung an einem von einem Sensor über ein Eingabeterminal eingegebenen Sensorsignal ausführt, umfassend:
einen Verarbeitungspfad (20A), durch den eine Verarbeitungsreihe an dem Sensorsignal ausgeführt wird;
eine Prüfsignalerzeugungsquelle (26), die dazu konfiguriert ist, ein Prüfsignal für eine Selbstdiagnose zu erzeugen und das Prüfsignal in den Verarbeitungspfad einzuspeisen;
ein Register (25A), das dazu konfiguriert ist, das Prüfsignal zu speichern; und
ein Bestimmungsmittel (30), das dazu konfiguriert ist, ein Ergebnis der Selbstdiagnose auf Basis des Prüfsignals zu bestimmen, nachdem die Verarbeitungsreihe durch den Verarbeitungspfad ausgeführt wurde,
wobei der Verarbeitungspfad einen Verstärker (23) beinhaltet, der dazu konfiguriert ist, das Prüfsignal mit einer variablen Verstärkung zu verstärken,
wobei die Prüfsignalerzeugungsquelle eine Vielzahl von Prüfsignalen nacheinander in den Verarbeitungspfad einspeist,
wobei der Verstärker dazu konfiguriert ist, ein erstes Prüfsignal der Vielzahl von Prüfsignalen mit einer ersten Verstärkung zu verstärken, und ein zweites Prüfsignal der Vielzahl von Prüfsignalen mit einer zweiten Verstärkung, die sich von der ersten Verstärkung unterscheidet, zu verstärken,
wobei das Register dazu konfiguriert ist, ein erstes verarbeitetes Signal zu speichern, das das mit der ersten Verstärkung verstärkte erste Prüfsignal ist, und ein zweites verarbeitetes Signal zu speichern, das das mit der zweiten Verstärkung verstärkte zweite Prüfsignal ist, und
wobei das Bestimmungsmittel dazu konfiguriert ist, das Ergebnis der Selbstdiagnose auf Basis des ersten verarbeiteten Signals und des zweiten verarbeiteten Signals zu bestimmen.

2. Integrierte Schaltung wie in Anspruch 1 beansprucht, ferner umfassend:
ein Umschaltmittel (21, 22), das dazu konfiguriert ist, ein in den Verarbeitungspfad (20A) eingespeistes Signal von dem Sensorsignal in das Prüfsignal umzuschalten.

3. Integrierte Schaltung wie in Anspruch 2 beansprucht, wobei die integrierte Schaltung einen normalen Betriebsmodus und einen Diagnosemodus aufweist, und
wobei das Umschaltmittel das Sensorsignal in dem normalen Betriebsmodus in den Verarbeitungspfad einspeist und das Prüfsignal in dem Diagnosemodus in den Verarbeitungspfad einspeist.

4. Integrierte Schaltung wie in einem der Ansprüche 1 bis 3 beansprucht, wobei der Verarbeitungspfad (20A) einen A-D-Wandler (24) beinhaltet, um das Prüfsignal von einem analogen Signal in ein digitales Signal umzuwandeln.

5. Diagnosesystem (10), umfassend:
die integrierte Schaltung wie in einem der Ansprüche 1 bis 4 beansprucht, und
eine Bestimmungsvorrichtung, die dazu konfiguriert ist, ein Ergebnis der Selbstdiagnose auf Basis des Prüfsignals zu bestimmen, nachdem die Verarbeitungsreihe durch den Verarbeitungspfad ausgeführt wurde.

## Revendications

1. Circuit intégré (20) qui exécute un traitement sur un signal d'entrée de capteur provenant d'un capteur par l'intermédiaire d'un terminal d'entrée, comprenant :
un chemin de traitement (20A) par lequel une série de traitements est exécutée sur le signal de capteur ;
une source de génération de signal de test (26) configurée pour générer un signal de test pour un autodiagnostic, et pour introduire le signal de test dans le chemin de traitement ;
un registre (25A) configuré pour stocker le signal de test ; et
un moyen de détermination (30) configuré pour déterminer un résultat de l'autodiagnostic, basé sur le signal de test après que la série de traitements ait été exécutée par le chemin de traitement,
dans lequel le chemin de traitement comporte un amplificateur (23) configuré pour amplifier le signal de test avec un gain variable,
dans lequel la source de génération de signal de test introduit séquentiellement une pluralité de signaux de test dans le chemin de traitement,
dans lequel l'amplificateur est configuré pour amplifier un premier signal de test parmi la pluralité de signaux de test avec un premier gain, et amplifier un deuxième signal de test parmi la pluralité de signaux de test avec un deuxième gain différent du premier gain,
dans lequel le registre est configuré pour stocker un premier signal traité qui est le premier signal de test amplifié avec le premier gain, et un deuxième signal traité qui est le deuxième signal de test amplifié avec le deuxième gain, et
dans lequel le moyen de détermination est configuré pour déterminer le résultat de l'autodiagnostic, basé sur le premier signal traité et le deuxième signal traité.

2. Circuit intégré selon la revendication 1, comprenant en outre :
un moyen de commutation (21, 22) configuré pour commuter un signal introduit dans le chemin de traitement (20A) à partir du signal de capteur vers le signal de test.

3. Circuit intégré selon la revendication 2, dans lequel le circuit intégré a un mode de fonctionnement normal et un mode de diagnostic, et
dans lequel le moyen de commutation introduit le signal de capteur dans le chemin de traitement en mode de fonctionnement normal, et introduit le signal de test dans le chemin de traitement en mode de diagnostic.

4. Circuit intégré selon l'une quelconque des revendications 1 à 3, dans lequel le chemin de traitement (20A) comporte un convertisseur A-D (24) pour convertir le signal de test d'un signal analogique en un signal numérique.

5. Système de diagnostic (10) comprenant :
le circuit intégré selon l'une quelconque des revendications 1 à 4 ; et
un dispositif de détermination configuré pour déterminer un résultat de l'autodiagnostic, basé sur le signal de test après que la série de traitements ait été exécutée par le chemin de traitement.
